Europäisches Patentamt

European Patent Office

Office européen des brevets

(19)

(11) Veröffentlichungsnummer: **0 077 979**
**B1**

# EUROPÄISCHE PATENTSCHRIFT

(12)

(45) Veröffentlichungstag der Patentschrift:
13.02.85

(21) Anmeldenummer: 82109503.1

(22) Anmeldetag: 14.10.82

(51) Int. Cl.⁴: **H 04 B 15/00**, H 03 F 1/52, H 02 H 9/04

(54) Verfahren und Schaltungsanordnung zur Kompensation von induzierten Störspannungen.

(30) Priorität: **27.10.81 DE 3142515**

(43) Veröffentlichungstag der Anmeldung:
**04.05.83 Patentblatt 83/18**

(45) Bekanntmachung des Hinweises auf die Patenterteilung:
**13.02.85 Patentblatt 85/7**

(84) Benannte Vertragsstaaten:
**DE FR NL**

(56) Entgegenhaltungen:
**DE - A - 1 512 778**
**DE - A - 2 535 072**
**DE - A - 2 907 853**
**DE - B - 1 286 128**
**GB - A - 1 096 196**
**US - A - 3 431 434**
**US - A - 3 440 556**

**Prospekt "AKTIVE**
**REDUKTIONS-SCHUTZEINRICHTUNG ARS",**
**Fernmelderkabel Zubehör, Jänner 1979**
**AEG-TELEFUNKEN, Backnang, BRD**

(73) Patentinhaber: **ANT Nachrichtentechnik GmbH,**
**Gerberstrasse 33, D-7150 Backnang (DE)**

(72) Erfinder: **Form, Ernst, Ing. grad., Th. Heuss-Strasse 51,**
**D-7157 Sulzbach (DE)**

(74) Vertreter: **Schickle, Gerhard, Dipl.-Ing. et al, ANT**
**Nachrichtentechnik GmbH Patent- und Lizenzabteilung**
**Gerberstrasse 33, D-7150 Backnang (DE)**

## Beschreibung

Die Erfindung betrifft ein Verfahren sowie eine Schaltungsanordnung zur Kompensation von durch äußere Felder in die Adern von Fernmeldekabeln induzierte Störspannungen, wobei mittels eines Verstärkers aus der Störspannung eine Kompensationsspannung gebildet wird und diese über einen Reduktionstransformator in die Gesamtheit der Fernmeldeadern induziert wird, wobei die Restspannung bei Normalbetrieb zur Nachregelung des Verstärkers dient und bei Übersteuerung, das heißt bei nicht ausreichender Kompensation, eine Alarmgabe erfolgt, und wobei bei defektem Verstärker keine Kompensation der Störspannung und damit ein automatisches Abschalten des Verstärkers erfolgt. Eine solche Einrichtung ist bekannt aus dem Prospekt »Aktive Reduktions-Schutzeinrichtung ARS«, Fernmeldekabel-Zubehör, Telefunken, 1979.

Bei Ausfall des Verstärkers wird dort die Einrichtung abgeschaltet und durch Kontaktgabe Alarm ausgelöst. Ferner wird dort bei Übersteuerung, das heißt bei Überschreitung der abbaubaren Spannung, zeitverzögert abgeschaltet und Alarm ausgelöst. Ein Nachteil dieses Konzeptes ist, daß nach dem Abschalten ein Wiedereinschalten des Verstärkers von Hand notwendig ist.

Aus der DE-OS 2 535 072 ist eine Schutzschaltung für einen Verstärker in einer Vorrichtung zur Kompensation von Störspannungen bekannt. Die Pilotader ist dort über einen Vorwiderstand mit einem Eingang des Verstärkers verbunden. Dem Vorwiderstand ist ein Fotowiderstand parallel geschaltet, der verhindern soll, daß der Verstärker ins Schwingen gerät, wenn der Vorwiderstand durch einen Relaiskontakt überbrückt wird. Bei dieser Ausführung ist ein Abschalten bei manchen Betriebsbedingungen, z. B. bei zu hohen Störspannungen, oder eine Alarmgabe nicht vorgesehen.

Der Erfindung liegt nun die Aufgabe zugrunde, ein Verfahren zur Kompensation eingangs genannter Art anzugeben, bei welchem mit Hilfe der Restspannung unterschieden werden kann, ob die Störspannung zu hoch (Übersteuerung) oder der Verstärker defekt ist.

Erfindungsgemäß wird diese Aufgabe durch die kennzeichnenden Merkmale des Patentanspruchs 1 gelöst.

Im Anspruch 2 ist eine Schaltungsanordnung zum Durchführen dieses Verfahrens angegeben.

Anspruch 3 gibt eine Weiterbildung der Schaltungsanordnung gemäß Anspruch 2 an.

Besondere Vorteile der Erfindung ergeben sich dadurch, daß nach Übersteuerung des Verstärkers kein Wiedereinschalten von Hand nötig ist. Da die Ämter, in denen Reduktionsschutzeinrichtungen in vielen Fällen betrieben werden, unbesetzt sind, kann dort die Erfindung vorzugsweise eingesetzt werden. Bei Übersteuerung erfolgt noch keine Abschaltung, jedoch wird Alarm ausgelöst. Die Kompensation ist daher auch in diesem Falle noch wirksam. Im Falle eines Defektes des Verstärkers erfolgt eine Abschaltung. Hier muß das Wartungspersonal sowieso zwecks Behebung des Defektes aktiv werden. Außerdem ist ein Abschalten des Verstärkers bei Defekt angebracht, um ihn vor möglichen Zerstörungen infolge annormaler Betriebszustände zu schützen.

Anhand der Zeichnungen wird die Erfindung nun näher erläutert. Es zeigt

Fig. 1 ein Prinzipschaltbild einer erfindungsgemäßen Kompensationseinrichtung und

Fig. 2 den prinzipiellen Aufbau der Verstärkungsregelungsschaltung.

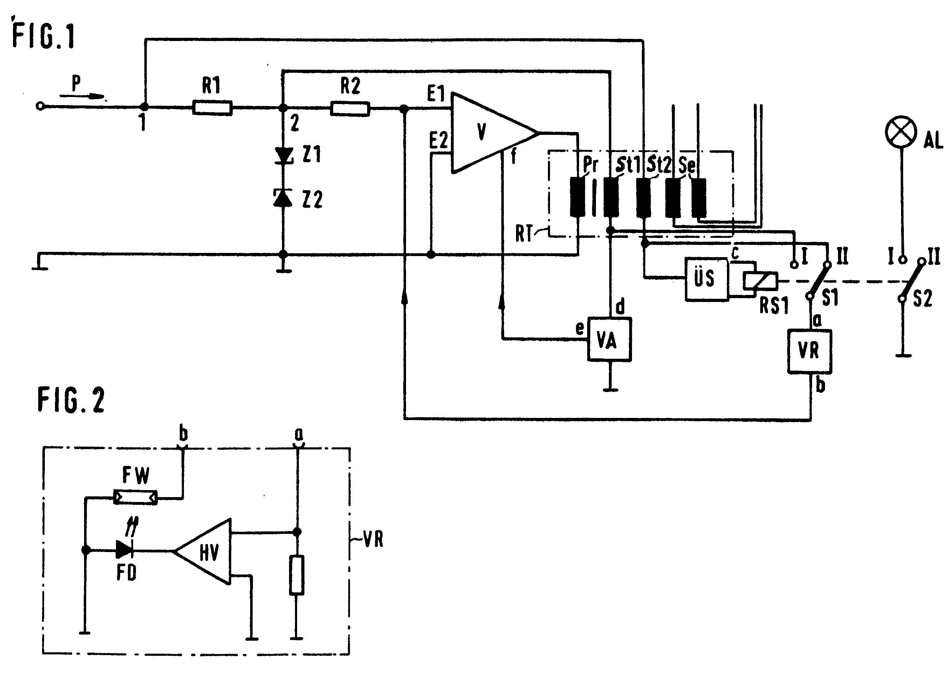

Die Pilotader des Fernmeldekabels — in Fig. 1 symbolisch dargestellt durch P — ist über einen Vorwiderstand R1 sowie einen weiteren Widerstand R2 mit dem ersten Eingang E1 des Verstärkers V verbunden. Der zweite Eingang E2 des Verstärkers V führt zur gemeinsamen Masseleitung. Der Ausgang des Verstärkers V ist an die Primärwicklung Pr des Reduktionstransformators RT angeschlossen. In die Sekundärwicklungen Se, die mit den Fernmeldesignaladern verbunden sind, oder die Teile der Fernmeldeadern sind, wird phasenrichtig eine Kompensationsspannung induziert, die durch Starkstromanlagen in die Fernmeldeadern induzierten Störspannungen kompensiert. Zur Gewinnung dieser Kompensationsspannung wird die Spannung auf der Pilotader mittels Verstärker V leistungsverstärkt und in die Primärwicklung Pr eingespeist. Die Höhe der Spannungsverstärkung des Verstärkers V wird durch einen Regelkreis bestimmt. Dazu wird der Steuerwicklung St2 des Reduktionstransformators RT eine Spannung entnommen, die über den Schalter S1 — Stellung II — dem Eingang a einer Verstärkungsregelungsschaltung VR zugeführt wird. Die Verstärkungsregelungsschaltung VR, deren prinzipieller Aufbau später beschrieben wird, ist in Fig. 2 dargestellt. Der Ausgang b der Verstärkungsregelungsschaltung VR ist mit dem ersten Eingang E1 des Verstärkers V verbunden, so daß das Ausgangssignal der Verstärkungsregelungsschaltung VR auf den Verstärker V einwirkt. Bei Normalbetrieb d. h. es erfolgt keine Übersteuerung durch zu hohe Störspannung, entspricht die Verstärkung des Verstärkers V der Spannung auf der Pilotader, dadurch daß die Verstärkungsregelschaltung VR über die Steuerwicklung St2 mit der Pilotader verbunden ist (Punkt 1). An die Steuerwicklung St2 ist außerdem ein Überspannungssensor ÜS angeschlossen. Der Überspannungssensor ÜS kann ein üblicher Spannungskomparator sein, der an seinem Ausgang c ein Signal aufweist, wenn das über die Steuerwicklung St2 zugeführte Potential am Punkt 1 einen bestimmten Schwellwert erreicht hat, nämlich den Übergangswert zwischen Normalbetrieb und Übersteuerung. Führt der Ausgang c des Überspannungssensors ÜS nun ein Signal — Übersteuerung —, so bewirkt die dem Überspannungssensor ÜS zugeordnete Einrich-

tung — Relais RS1 — gleichzeitiges Umschalten der Schalter S1 und S2 von Position II in Position I. Über den Schalter S2 in Position I erfolgt nun Alarmgabe, beispielsweise durch Aufleuchten einer Alarmlampe AL. Über den Schalter S1 in Position I wird der Eingang der Verstärkungsregelschaltung VR nun auf Punkt 2 gelegt. Die Verstärkungsregelung erfolgt nun in Abhängigkeit des Spannungsabfalls am Vorwiderstand R1, der im wesentlichen durch den Strom über die gegensinnig geschalteten Zenerdioden Z1 und Z2 verursacht wird. Z1 und Z2 sind dabei so dimensioniert, daß die an ihnen abfallende Gesamtspannung dem Spitzenwert der Pilotaderspannung entspricht, die noch keine Übersteuerung verursacht.

Im Falle eines Defektes des Verstärkers V erfolgt keine Reduzierung der Störspannung mehr. Dadurch erscheint am Eingang d der Verstärkerabschalteinrichtung VA über Punkt 2 und die Steuerwicklung St1 eine so hohe Spannung, daß der Ausgang e von VA ein Signal führt, welches den Verstärker V über einen Steuereingang f abschaltet.

Die Verstärkerabschalteinrichtung VA kann dabei ähnlich aufgebaut sein wie der Übersteuerungssensor ÜS, d. h. am Ausgang e steht immer dann ein Signal, wenn die Spannung am Eingang von VA einen bestimmten Schwellwert, nämlich die Abschaltschwelle, überschreitet. Diese Abschaltschwelle entspricht naturgemäß einem höheren Spannungswert als die Ansprechschwelle des Übersteuerungssensors ÜS.

Für den Übersteuerungssensor ÜS wie auch für die Verstärkerabschalteinrichtung VA können handelsübliche integrierte Bausteine, z. B. µA 741 verwendet werden.

Die Verstärkungsregelungsschaltung VR kann wie in Fig. 2 dargestellt aufgebaut sein. An dem Eingang a liegt die Restspannung. Diese wird dem Hilfsverstärker HV zugeführt. Der Ausgang des Hilfsverstärkers HV steuert eine Fotodiode FD, die mit einem Fotowiderstand FW optisch gekoppelt ist. Die Änderung des Fotowiderstandes FW beeinflußt das Eingangsspannungsteilerverhältnis des Verstärkers V und dadurch dessen Verstärkung.

Dieses Konzept für die Verstärkungsregelung wurde aus folgenden Gründen gewählt:

Gefordert ist, daß der Verstärker V einen Verstärkungsfaktor einhält, der die Restspannung bzw. den Reduktionsfaktor auf den kleinstmöglichen Wert bringt.

In der gewählten Schaltung regelt die Höhe der Restspannung den Verstärkungsfaktor mit Hilfe der Fotodiode FD und des Fotowiderstandes FD. Durch diese sowohl kapazitiv sowie galvanisch sehr gute Entkopplung des Eingangs vom Ausgang ist die Schwingneigung sehr gering. Außerdem ist der Isolationswiderstand und die Spannungsfestigkeit sehr hoch.

**Patentansprüche**

1. Verfahren zur Kompensation von durch äußere Felder in die Adern von Fernmeldekabeln induzierte Störspannungen, wobei mittels eines Verstärkers (V) aus der Störspannung eine Kompensationsspannung gebildet wird und diese über einen Reduktionstransformator (RT) in die Gesamtheit der Fernmeldeadern induziert wird, wobei die Restspannung bei Normalbetrieb zur Nachregelung des Verstärkers dient und bei Übersteuerung, das heißt bei nicht ausreichender Kompensation, eine Alarmgabe erfolgt, wobei bei defektem Verstärker keine Kompensation der Störspannung und damit ein automatisches Abschalten des Verstärkers erfolgt, dadurch gekennzeichnet, daß bei Übersteuerung umgeschaltet wird auf Nachregelung in Abhängigkeit zum Spannungsabfall an einem Vorwiderstand (R1) zwischen Pilotader (P) und einem ersten Verstärkereingang (E1) ohne Erreichen der Abschaltschwelle des Verstärkers.

2. Schaltungsanordnung zum Durchführen des Verfahrens nach Anspruch 1, wobei der Verstärker (V) mit der Primärwicklung (Pr) des Reduktionstransformators (RT) verbunden ist und die Sekundärwicklungen (Se) mit den Fernmeldesignaladern verbunden sind und wobei eine Steuerwicklung (St2) des Reduktionstransformators einerseits mit einem Übersteuerungssensor (ÜS) und andererseits mit der Pilotader (P) verbunden ist, dadurch gekennzeichnet, daß der erste Eingang (E1) des Verstärkers (V) über eine Serienschaltung aus Vorwiderstand (R1) und weiterem Widerstand (R2) mit der Pilotader (P) verbunden ist, daß der Verbindungspunkt von Vorwiderstand (R1) und weiterem Widerstand (R2) mit einem Anschluß einer Serienschaltung gegensinnig geschalteter Zenerdioden (Z1, Z2) verbunden ist, daß der andere Anschluß der Serienschaltung sowohl mit dem zweiten Eingang (E2) des Verstärkers als auch mit der gemeinsamen Masseleitung verbunden ist, daß eine weitere Steuerwicklung (St1) des Reduktionstransformators (RT) einerseits mit dem Eingang (d) einer Verstärkerabschalteinrichtung (VA) und andererseits mit dem Verbindungspunkt von Vorwiderstand (R1) und weiterem Widerstand (R2) verbunden ist, daß der Ausgang (e) der Verstärkerabschalteinrichtung (VA) mit einem Steuereingang (f) des Verstärkers (V) verbunden ist, daß dem Übersteuerungssensor (ÜS) eine Einrichtung (Rs1) zugeordnet ist, mittels derer zwei Schalter (S1, S2) umschaltbar sind, daß der Zentralkontakt des ersten Schalters (S1) über eine Verstärkungsregelungsschaltung (VR) mit dem ersten Eingang (E1) des Verstärkers verbunden ist, daß die beiden Umschaltkontakte (I; II) des ersten Schalters (S1) an je eine der Steuerwicklungen (St1, St2) des Reduktionstransformators angeschlossen sind und daß der zweite Schalter (S2) derart mit der Einrichtung zur Alarmgabe (AL) verbunden ist, daß bei Übersteuerung Alarmabgabe erfolgt.

3. Schaltungsanordnung nach Anspruch 2, dadurch gekennzeichnet, daß die Verstärkungsregelschaltung (VR) aus einem Hilfsverstärker (HV) besteht, dessen Eingang an einen Widerstand angeschlossen ist, an dem die Restspannung abfällt, daß der Ausgang des Hilfsverstärkers (HV) mit einer Fotodiode (FD) verbunden ist und daß die Fotodiode (FD) mit einem Fotowiderstand (FW) optisch gekoppelt ist, der mit einem Steuereingang des Verstärkers verbunden ist.

## Claims

1. Method for the compensation of interference voltages induced by external fields into the cores of telecommunications cables, wherein a compensation voltage is formed from the interference voltage by means of an amplifier (V) and induced by way of a stepdown transformer (RT) into the entirety of the telecommunications cores, wherein the residual voltage in normal operation serves for the follow-up regulation of the amplifier and a giving of an alarm takes place in the case of overloading, that is to say in the case of inadequate compensation, when no compensation of the interference voltage and therewith an automatic switching-off of the amplifier takes place when the amplifier is defective, characterised thereby, that in the case of overloading, follow-up regulation in dependence on the voltage drop at an input resistor (R1) between pilot core (P) and a first amplifier input (E1) is switched over to without reaching the switch-off threshold of the amplifier.

2. Circuit arrangement for the performance of the method according to claim 1, wherein the amplifier (V) is connected with the primary winding (Pr) of the step-down transformer (RT) and the secondary windings (Se) are connected with the telecommunications cores and wherein a control winding (St2) of the step-down transformer is connected on the one hand with the overload sensor (ÜS) and on the other hand with the pilot core (P), characterised thereby, that the first input (E1) of the amplifier (V) is connected through a series connection of input resistor (R1) and further resistor (R2) with the pilot core (P), that the junction of input resistor (R1) and further resistor (R2) is connected with a connection to a series connection of oppositaly connected Zener diodes (Z1, Z2), that the other connection to the series connection is connected with the second input (E2) of the amplifier as well as with the common earth line, that a further control winding (St1) of the step-down transformer (RT) is connected on the one hand with the input (d) of an amplifier switch-off equipment (VA) and on the other hand with the junction of input resistor (R1) and further resistor (R2), that the output (e) of the amplifier switch-off equipment (VA) is connected with a control input (f) of the amplifier (V), that the overload sensor (ÜS) is associated with an equipment (Rs1), by means of which two switches (S1, S2) can be switched over, that the centre contact of the first switch (S1) is connected through an amplifier regulation circuit (VR) with the first input (E1) of the amplifier, that both the change-over contacts (I; II) of the first switch (S1) are each connected to a respective one of the control windings (St1, St2) of the step-down transformer and that the second switch (S2) is connected in such a manner with the equipment (AL) for giving alarm that giving of an alarm takes place in the case of overloading.

3. Circuit arrangement according to claim 2, characterised thereby, that the amplifier regulation circuit (VR) consists of an auxiliary amplifier (HV), the input of which is connected to a resistor, across which the residual voltage drops, that the output of the auxiliary amplifier (HV) is connected with a photo-diode (FD) and that the photo-diode (FD) is optically coupled with a photoresistor (FW), which is connected with a control input of the amplifier.

## Revendications

1. Procédé pour la compensation des tensions de bruit induites par des champs extérieurs dans les conducteurs de câbles de télécommunication, un amplificateur (V) délivrant à partir de la tension de bruit une tension de compensation qu'un transformateur réducteur (RT) induit dans l'ensemble des conducteurs de télécommunication, la tension résiduelle servant à la régulation de correction de l'amplificateur en fonctionnement normal, une alarme étant déclenchée en cas de surmodulation, c'est-à-dire de compensation insuffisante, et aucune compensation de la tension de bruit n'étant produite quand l'amplificateur défectueux, d'où une coupure automatique de l'amplificateur, ledit procédé étant caractérisé en ce qu'une surmodulation commute sur la régulation de correction en fonction de la chute de tension aux bornes d'une résistance addtionnelle (R1) entre le conducteur pilote (P) et une première entrée (E1) de l'amplificateur, sans atteindre le seuil de coupure de ce dernier.

2. Circuit pour la mise en oeuvre du procédé selon revendication 1, l'amplificateur (V) étant relié à l'enroulement primaire (Pr) du transformateur réducteur (RT) et les enroulements secondaires (Se) aux conducteurs des signaux de télécommunication, et un enroulement de commande (St2) du transformateur réducteur étant relié d'une part à un capteur de surmodulation (US) et d'autre part au conducteur pilote (P), ledit circuit étant caractérisé en ce que la première entrée (E1) de l'amplificateur (V) est reliée au conducteur pilote (P) par le montage en série d'une résistance additionnelle (R1) et d'une seconde résistance (R2); le point de connexion de la résistance additionnelle (R1) et de la seconde résistance (R2) est relié à une borne du montage en série de diodes Zener (Z1, Z2) branchées en sens inverse; la seconde borne du montage en série est reliée à la fois à la seconde entrée (E2) de l'amplificateur et au fil de masse commun; un second enroulement de commande (St1) du transformateur réducteur (RT) est relié d'une part à l'entrée (d) d'un dispositif de coupure de l'amplificateur (VA) et d'autre part au point de connexion de la résistance additionnelle (R1) et de la seconde résistance (R2); la sortie (e) du dispositif de coupure de l'amplificateur (VA) est reliée à une entrée de commande (f) de l'amplificateur (V); un dispositif (Rs1) affecté au capteur de surmodulation (US) permet de commuter deux inverseurs (S1, S2); le contact central du premier inverseur (S1) est relié par un dispositif de commande automatique de gain (VR) à la première entrée (E1) de l'amplificateur; les deux contacts inverseurs (I; II) du premier inverseur (S1) sont reliés chacun à un des enroulements de commande (St1, St2) du transformateur réducteur; et le second inverseur (S2) est relié au dispositif déclenchant l'alarme (AL) de façon à produire une alarme en cas de surmodulation.

3. Circuit selon revendication 2, caractérisé en ce que le circuit de commande automatique de gain (VR) est constitué par un amplificateur auxiliaire (HV), dont l'entrée est reliée à une résistance produisant une chute de la tension résiduelle; la sortie de l'amplificateur auxiliaire (HV) est reliée à une photodiode (FD); et la photodiode (FD) est couplée optiquement à une photorésistance (FW) reliée à une entrée de commande de l'amplificateur.

FIG.1

FIG.2